(19) **Europäisches Patentamt**

**European Patent Office**

**Office européen des brevets**

(11) **EP 0 997 778 A2**

(12) **EUROPEAN PATENT APPLICATION**

(43) Date of publication:
03.05.2000 Bulletin 2000/18

(51) Int. Cl.$^7$: **G03F 7/20**, G02B 13/14

(21) Application number: 99120933.9

(22) Date of filing: 02.11.1999

(84) Designated Contracting States:
**AT BE CH CY DE DK ES FI FR GB GR IE IT LI LU MC NL PT SE**
Designated Extension States:
**AL LT LV MK RO SI**

(30) Priority: **30.10.1998 JP 31031598**

(71) Applicant: **NIKON CORPORATION**
**Tokyo 100-0005 (JP)**

(72) Inventors:
• **Komine, Norio,**
**c/o NIKON CORPORATION**
**Chiyoda-ku, Tokyo (JP)**
• **Jinbo, Hiroki,**
**c/o NIKON CORPORATION**
**Chiyoda-ku, Tokyo (JP)**

(74) Representative: **HOFFMANN - EITLE**
**Patent- und Rechtsanwälte**
**Arabellastrasse 4**
**81925 München (DE)**

(54) **Optical member and projection optical system for photolithography using the same**

(57)  An optical member is provided for used by a photolithography projection system that has a sub-200 nm wavelength vacuum ultraviolet light source. The optical member includes silica glass that has an ArF excimer laser-induced bulk attenuation coefficient $\Delta\gamma$ that substantially satisfies the equation, $\Delta\gamma = ks \cdot \varepsilon^2 \cdot P^1$ when an ArF excimer laser with an energy density less than or equal to about 200 mJ/cm$^2$ per pulse is used for illumination, where ks is less than about $9.1 \times 10^{-13}$ cm$^{-1}$, $\varepsilon$ is per pulse energy density, P is pulse count, and ks is a proportionality constant.

**FIG. 1**

Description

## BACKGROUND OF THE INVENTION

### Field of the Invention

The present invention relates to an optical member and a projection optical system utilizing the optical member, wherein the projection optical system is used for photolithographic reproduction upon a second object (such as a wafer or the like) of a pattern formed upon a first object (such as a mask or the like). In particular, the present invention relates to an optical member and an optical lithography projection system utilizing the optical member, wherein the optical lithography projection system uses a vacuum ultraviolet light source with a wavelength of less than about 200 nm.

### Discussion of the Related Art

In recent years, in transferring integrated circuit patterns of IC, LSI, and the like, reduction exposure apparatus were used. As density of integrated circuits increases, the projection optical systems used by such apparatus require a wide exposure region and an increasingly higher resolution over the entire exposure region. Shortening of the exposure light wavelength or increasing numeric aperture (NA) of the optical system have been considered for improving resolution.

Exposure light wavelength has been reduced from the g-line (436 nm) to the i-line (365 nm), then to the KrF (248 nm) or ArF (193 nm) excimer laser. In general, optical glass is used for a lens (optical member) of an illumination optical system or projection optical system of a reduction projection exposure apparatus (photolithography apparatus) utilizing a light source with a wavelength longer than the i-line. Optical transmissivity rapidly declines in the wavelength region below the i-line. Transparency of most optical glasses is particularly poor in the wavelength region below 250 nm.

Therefore only silica glass and crystalline calcium fluoride can be used as the materials of construction of lenses for an optical system of a reduction projection exposure apparatus utilizing an excimer laser as a light source. These two materials are indispensable for chromatic aberration correction of an ArF excimer laser image-forming optical system.

However, when sub-200 nm wavelength vacuum ultraviolet light is used for exposure (such as when an ArF excimer laser is used as a light source) and the projection optical system is illuminated by vacuum ultraviolet light, bulk transmissivity decreases (bulk attenuation coefficient increases) for the silica glass and crystalline calcium fluoride material that constitute the lenses of the projection optical system. This transmissivity decrease results in a problem of transmissivity (throughput) loss for the projection optical system as a whole. For example, although a reduction projection apparatus is required to operate for 10 years or so, desired performance can not be maintained for even shorter time periods due to such deterioration in transmissivity. Therefore there is a concern that operational life of such a reduction projection apparatus will be reduced.

## SUMMARY OF THE INVENTION

Accordingly, the present invention is directed to an optical member and a projection optical system for photolithography that substantially obviate the problems due to limitations and disadvantages of the related art.

An object of the present invention is to provide a projection optical system that can maintain desired performance over a longer period of time for a reduction projection exposure apparatus that utilizes exposure light with a sub-200 nm vacuum ultraviolet wavelength.

Additional features and advantages of the invention will be set forth in the description that follows, and in part will be apparent from the description, or may be learned by practice of the invention. The objectives and other advantages of the invention will be realized and attained by the structure particularly pointed out in the written description and claims hereof as well as the appended drawings.

To achieve these and other advantages and in accordance with the purpose of the present invention, as embodied and broadly described, the present invention provides an optical member used by a photolithography projection system having a sub-200 nm wavelength vacuum ultraviolet light source, the optical member including silica glass haivng an ArF excimer laser-induced bulk attenuation coefficient $\Delta\gamma$ that substantially satisfies the equation, $\Delta\gamma = ks \cdot \varepsilon^2 \cdot P^1$ when an ArF excimer laser with an energy density less than or equal to about 200 mJ/cm$^2$ per pulse is used for illumination, wherein ks is less than about $9.1 \times 10^{-13}$ cm$^{-1}$, $\varepsilon$ is per pulse energy density, P is pulse count, and ks is a proportionality constant.

In another aspect, the present invention provides an optical member used by a photolithography projection system using a vacuum ultraviolet light source with a wavelength less than 200 nm, the optical member including crystalline calcium fluoride having an ArF excimer laser-induced bulk attenuation coefficient $\Delta\gamma$ that substantially satisfies

the equation, $\Delta\gamma = kc \cdot \varepsilon^{\alpha}$ when an ArF excimer laser with an energy density of less than about 20 mJ/cm$^2$ per pulse is used for illumination, wherein $\varepsilon$ is per pulse energy density, $\alpha$ is at least about 0.1 and less than or equal to about 1.0, and kc is a proportionality constant that is less than or equal to about $0.005\alpha$ cm$^{-1}$.

It is to be understood that both the foregoing general description and the following detailed description are exemplary and explanatory and are intended to provide further explanation of the invention as claimed.

## BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:

FIG. 1 schematically shows an example of a reduction exposure apparatus that has a projection optical system of the present invention; and

FIG. 2 schematically shows the construction of a projection optical system according to a preferred embodiment of the present invention.

## DETAILED DESCRIPTION OF THE PREFERRED EMBODIMENTS

Reference will now be made in detail to the preferred embodiments of the present invention, examples of which are illustrated in the accompanying drawings.

As a result of dedicated research related to the increase in bulk attenuation of silica glass or crystalline calcium fluoride (materials that determine operational life of the projection optical system) during illumination by an ArF excimer laser, the inventors of the present invention discovered that when the silica glass and crystalline calcium fluoride satisfy a certain relationship with respect to a bulk attenuation coefficient induced by ArF excimer laser irradiation, the transmissivity decline of the silica glass or crystalline calcium fluoride can be predicted based upon accelerated testing by use of vacuum ultraviolet light having an intensity significantly higher than that of actual ultraviolet light used in an actual projection optical system.

Specifically, by the use of such silica glass and calcium fluoride for a projection optical system used for photolithography utilizing a sub-200 nm vacuum ultraviolet wavelength light source, the increase of bulk attenuation can be accurately predicted, and a photolithography apparatus can be provided that assures stable projection exposure.

The present invention provides an optical member that is used by a photolithography projection system that has a sub-200 nm wavelength vacuum ultraviolet light source, the optical member being constructed from silica glass that has an ArF excimer laser-induced bulk attenuation coefficient $\Delta\gamma$ that substantially satisfies the equation, $\Delta\gamma = ks \cdot \varepsilon^2 \cdot P^1$ when an ArF excimer laser with an energy density less than or equal to about 200 mJ/cm$^2$ per pulse is used for illumination, where ks is less than about $9.1 \times 10^{-13}$ cm$^{-1}$, $\varepsilon$ is per pulse energy density, P is pulse count, and ks is a proportionality constant. The bulk attenuation coefficient at the wavelength of an ArF excimer laser is preferably less than 0.036 cm$^{-1}$ after illumination by 10$^6$ pulses of ArF excimer laser light at a per pulse energy density of 200 mJ/cm$^2$.

In another aspect, the present invention provides an optical member used by a photolithography projection system that utilizes a vacuum ultraviolet light source with a wavelength less than about 200 nm, wherein the optical member is constructed from crystalline calcium fluoride that has an ArF excimer laser-induced bulk attenuation coefficient $\Delta\gamma$ that substantially satisfies the equation, $\Delta\gamma = kc \cdot \varepsilon^{\alpha}$ when an ArF excimer laser with an energy density of less than about 20 mJ/cm$^2$ per pulse is used for illumination, where $\varepsilon$ is per pulse energy density, $\alpha$ is at least about 0.1 and less than or equal to about 1.0, and kc is a proportionality constant that is less than or equal to about $0.005\alpha$ cm$^{-1}$. The bulk attenuation coefficient is preferably less than about 0.1 cm$^{-1}$ at the wavelength of ArF excimer laser light after illumination of the crystalline calcium fluoride by 10$^4$ pulses of ArF excimer laser light at a per pulse energy density of 20 mJ/cm$^2$.

Furthermore, the present invention provides a photolithographic projection system including an optical member formed from the above mentioned crystalline calcium fluoride and an optical member formed from the above mentioned silica glass.

In order to find factors that determine the operational life of a projection optical system, the inventors of the present invention carried out ArF excimer laser illumination accelerated testing on various types of silica glass and crystalline calcium fluoride in a wide energy density range of 0.5 to 200 mJ/cm$^2$. As a result, it was discovered that the increase of bulk attenuation due to ArF excimer laser light illumination during actual use in a projection optical system for photolithography can be accurately estimated if silica glass has a bulk attenuation coefficient $\Delta\gamma$ that substantially

satisfy the following equation:

$$\Delta\gamma = ks \cdot \varepsilon^2 \cdot P^1, \qquad (1)$$

where 0.5 mJ/cm$^2 \leq \varepsilon \leq$ 200 mJ/cm$^2$.

Here $\varepsilon$ is per pulse energy density of the ArF excimer laser, and P represents the pulse count.

Further, it was discovered that the increase of bulk attenuation due to ArF excimer laser light illumination during actual use in a projection optical system for photolithography can be accurately estimated if the crystalline calcium fluoride has a bulk attenuation coefficient $\Delta\gamma$ that substantially satisfies the following equation:

$$\Delta\gamma = kc \cdot \varepsilon^{\alpha}, \qquad (2)$$

wherein 0.5 mJ/cm$^2 \leq \varepsilon \leq$ 200 mJ/cm$^2$.

Here $\alpha$ is at least about 0.1 and less than or equal about to 1.0.

Although the $\Delta\gamma$ for silica glass is proportional to the number of illuminating pulses, the $\Delta\gamma$ of crystalline calcium fluoride is not dependent upon the pulse count. That is to say, although adsorption by silica glass increases linearly with respect to pulse count, absorptivity of crystalline calcium fluoride is only affected by energy density (unaffected by pulse count) since absorptivity of crystalline calcium fluoride reaches a saturation point immediately after the start of illumination.

In Equations (1) and (2), ks and kc are parameters that indicate the degree of durability of silica glass and crystalline calcium fluoride, respectively. That is to say, durability with respect to ultraviolet light can be said to be better as these parameters become smaller. Thus by using silica glass or crystalline calcium fluoride that obeys Equations (1) or (2), with an appropriate respective ks and kc parameter range as the lens material, a projection optical system that does not lose performance even during long-term operation can be provided.

Below, the ks and kc value ranges are described for silica glass and crystalline calcium fluoride, which make possible the provision of a projection optical system that does not lose performance even during long term operation. Lenses with various radii of curvature become necessary for aberration correction of a projection optical system of a reduction projection exposure apparatus that utilizes an ArF excimer laser as a light source. Total optical path length sometimes reaches 1000 mm for the entire projection optical system in order to carry out such aberration correction. Therefore a bulk transmissivity of at least 99.75% and 99.80% per 1 cm is required for silica glass and crystalline calcium fluoride, respectively, at 193.4 nm wavelength. Upon conversion from the bulk transmissivity values, these values correspond to respective bulk attenuation coefficients of 0.0025 cm$^{-1}$ and 0.0020 cm$^{-1}$.

The actual bulk attenuation coefficient at 193.4 nm wavelength prior to illumination by exposure light includes an initial attenuation coefficient of the lens material. The initial attenuation coefficient at 193.4 nm wavelength is better than 0.0015 cm$^{-1}$ or 0.0010 cm$^{-1}$ for high purity synthetic silica glass or fluorite respectively. Such an initial attenuation coefficient is largely due to bulk fundamental light scattering loss in the case of silica glass, or due to bulk light scattering loss and internal absorption in the case of crystalline calcium fluoride. Therefore the permissible range of bulk attenuation (mostly due to absorption) induced by illumination by an ArF excimer layer is less than about 0.001 cm$^{-1}$.

The per pulse energy density required for an ArF excimer laser is about 0.1 mJ/cm$^2$ within a projection optical system of a reduction projection exposure apparatus utilizing an ArF excimer laser. Moreover, the exposure light (ArF excimer laser light) pulse count during illumination of a projection optical system over 10 years of operation of a reduction projection exposure apparatus will reach roughly $1.1 \times 10^{11}$ pulses.

Therefore ks was determined such that the value of $\Delta\gamma$ in Equation (1) becomes less than about 0.001 cm$^{-1}$ (substituting 0.1 mJ/cm$^2$ for $\varepsilon^2$, and substituting $1.1 \times 10^{11}$ pulses for P). Therefore kc was also determined according to Equation (2) so that the value of $\Delta\gamma$ becomes less than 0.001 cm$^{-1}$. These ranges are as follows:

$$ks \leq 9.1 \times 10^{-13} \text{ cm}^{-1} \qquad (3)$$

$$kc \leq 0.005\alpha \text{ cm}^{-1}, \text{ where } \alpha \text{ is 0.1 to 1.}$$

In other words, by construction of a projection optical system using silica glass and crystalline calcium fluoride that satisfy these conditions, a projection optical system can be provided that does not undergo degradation of performance during long-term operation (about 10 years) of an exposure apparatus.

The conditions of Equation (3) above can be restated as conditions of accelerated testing as described below. That is to say, by construction of lenses from silica glass material that has a bulk attenuation coefficient less than or equal to 0.036 cm$^{-1}$ resulting from illumination by 10$^6$ pulses at the ArF wavelength at a per pulse energy density of 200 mJ/cm$^2$ ArF excimer laser light, and by construction of lenses from crystalline calcium fluoride material that has a bulk attenuation coefficient less than or equal to 0.1 cm$^{-1}$ at the ArF wavelength after illumination by $10^4$ pulses of ArF excimer laser light at a per pulse energy density of 20 mJ/cm$^2$, performance of a projection optical system can be maintained even during long-term operation.

Although accelerated testing of the present invention is carried out using ArF excimer laser illumination, the present invention is not limited to a reduction projection exposure apparatus using an ArF excimer laser as a light source. The present invention can be used for any projection exposure apparatus that utilizes a sub-200 nm wavelength vacuum ultraviolet light as a light source. Such a projection exposure apparatus is also within the scope of the present invention.

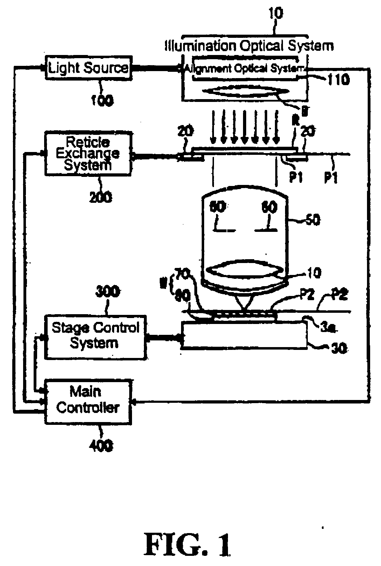

FIG. 1 schematically shows the basic construction of a reduction exposure apparatus according to a preferred embodiment of the present invention. This apparatus comprises a stage 30 that is constructed so that wafer W (coated with a photosensitive material) can be placed at surface 3a, an illumination optical system 10 that is provided with ArF excimer laser light as exposure light to uniformly illuminate a mask (reticle) R upon which is drawn an integrated circuit pattern, a light source 100 (an ArF excimer laser in this embodiment) that provides exposure light to illumination optical system 10, and a projection optical system 50 that is placed between the mask R front side plane P1 (object plane) and a second plane P2 (image plane) that coincides with the surface of wafer W. Illumination optical system 10 also includes an alignment optical system 110 that is used for adjustment of the relative positions of mask R and wafer W. Reticle exchange system 200 is placed upon reticle stage 20. Reticle exchange system 200 exchanges and transports reticle R. Reticle exchange system 200 include a stage driver in order to move reticle stage 20 parallel to surface 3a of wafer stage 30. Projection optical system 50 has an alignment optical system corresponding to the type of scanning of the apparatus.

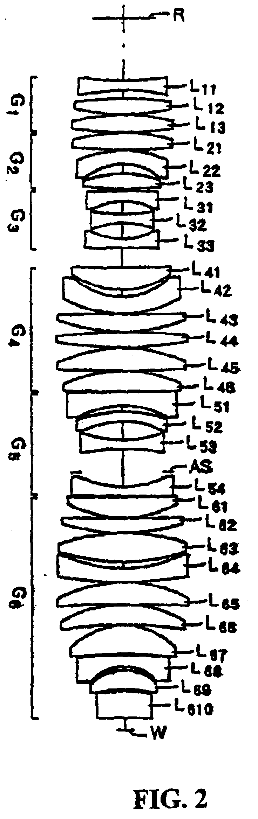

FIG. 2 schematically shows the construction of a projection optical system of the reduction exposure apparatus of FIG. 1. As shown in FIG. 2, the projection optical system of this working example comprises (in order from the second object side or reticle R side) a positive power second lens group G1, a positive power second lens group G2, a negative power third lens group G3, a positive power fourth lens group G4, a negative power fifth lens group G5, and a positive power sixth lens group G6. The object side (reticle R side) and image side (wafer side) are nearly telecentric and have a reducing magnification. Furthermore, the numeric aperture NA at the image side of this projection optical system is 0.6, and projection magnification is 1/4. Table 1 list various parameters of the lenses. In Table 1, the first column lists the number of each lens surface from the object side (reticle side), the second column r lists the radius of curvature of each lens surface, the third column d lists spacing between each of the lens surfaces, the fourth column lists the material of each lens, and the fifth column indicates the lens group number relating to each lens.

Optical members of the present invention were used as the silica glass and crystalline calcium fluoride optical members listed in Table 1 for a projection exposure apparatus. Specifically, these optical members comprise silica glass that has a bulk attenuation coefficient less than or equal to about 0.036 cm$^{-1}$ resulting from illumination by $10^6$ pulses at the ArF wavelength at a per pulse energy density of 200 mJ/cm$^2$ ArF excimer laser light and crystalline calcium fluoride that has a bulk attenuation coefficient less than or equal to 0.1 cm$^{-1}$ at the ArF wavelength after illumination by $10^4$ pulses of ArF excimer laser light at a per pulse energy density of 20 mJ/cm$^2$.

## TABLE 1

| | r | d | | |
|---|---|---|---|---|
| 0 | (Reticle) | 103.390978 | | |
| 1 | -453.18731 | 17.000000 | $SiO_2$ | $G_1$ |
| 2 | 370.52697 | 13.613089 | | |
| 3 | 710.84358 | 26.000000 | $SiO_2$ | $G_1$ |
| 4 | -350.78200 | 1.000000 | | |
| 5 | 367.53957 | 28.000000 | $SiO_2$ | $G_1$ |
| 6 | -567.47540 | 1.000000 | | |
| 7 | 289.50734 | 29.000000 | $SiO_2$ | $G_2$ |
| 8 | -899.09021 | 1.000000 | | |
| 9 | 199.45895 | 23.000000 | $SiO_2$ | $G_2$ |
| 10 | 103.61200 | 15.764153 | | |
| 11 | 188.56105 | 25.800000 | $SiO_2$ | $G_2$ |
| 12 | -574.230881 | 4.242446 | | |
| 13 | 3000.00000 | 16.616840 | $SiO_2$ | $G_3$ |
| 14 | 118.18165 | 21.762847 | | |
| 15 | -336.11504 | 15.000000 | $SiO_2$ | $G_3$ |
| 16 | 161.39927 | 25.871656 | | |
| 17 | -120.57109 | 15.000000 | $SiO_2$ | $G_3$ |
| 18 | ∞ | 33.995810 | | |

| 19 | -2985.44349 | 36.979230 | SiO$_2$ | G$_4$ |
| 20 | -150.10550 | 11.683590 | | |
| 21 | -122.25791 | 28.000000 | SiO$_2$ | G$_4$ |
| 22 | -204.99200 | 1.000000 | | |
| 23 | ∞ | 29.240000 | SiO$_2$ | G$_4$ |
| 24 | -312.57215 | 1.000000 | | |
| 25 | 965.45342 | 27.000000 | SiO$_2$ | G$_4$ |
| 26 | -643.40298 | 1.000000 | | |
| 27 | 258.67450 | 39.000000 | CaF$_2$ | G$_4$ |
| 28 | -2967.14698 | 1.000000 | | |
| 29 | 246.35328 | 35.600000 | CaF$_2$ | G$_4$ |
| 30 | -2970.04481 | 1.000000 | | |
| 31 | ∞ | 24.00000 | SiO$_2$ | G$_5$ |
| 32 | 157.63171 | 10.667015 | | |
| 33 | 234.15227 | 17.000000 | SiO$_2$ | G$_5$ |
| 34 | 31.502404 | | | |
| 35 | -200.72428 | 15.000000 | SiO$_2$ | G$_5$ |
| 36 | 432.89447 | 37.939196 | | |
| 37 | (Aperture Stop) | 24.400000 | | |
| 38 | -175.71116 | 17.000000 | SiO$_2$ | G$_5$ |
| 39 | -2985.98357 | 1.000000 | | |

| | | | | |
|---|---|---|---|---|
| 40 | -2985.99700 | 35.500000 | CaF$_2$ | G$_6$ |
| 41 | -189.63629 | 1.000000 | | |
| 42 | -3000.00000 | 24.400000 | SiO$_2$ | G$_6$ |
| 43 | -350.29744 | 1.000000 | | |
| 44 | 362.38815 | 46.500000 | CaF$_2$ | G$_6$ |
| 45 | -361.31567 | 10.870000 | | |
| 46 | -251.97148 | 23.000000 | SiO$_2$ | G$_6$ |
| 47 | -662.28158 | 1.000000 | | |
| 48 | 238.98700 | 38.100000 | CaF$_2$ | G$_6$ |
| 49 | 1994.63265 | 1.000000 | | |
| 50 | 211.51173 | 33.400000 | CaF$_2$ | G$_6$ |
| 51 | 720.00000 | 1.000000 | | |
| 52 | 129.92966 | 46.000000 | CaF$_2$ | G$_6$ |
| 53 | 669.85166 | 2.783304 | | |
| 54 | 970.74182 | 19.986222 | SiO$_2$ | G$_6$ |
| 55 | 78.20244 | 6.273142 | | |
| 56 | 86.12755 | 32.522737 | SiO$_2$ | G$_6$ |
| 57 | 230.00000 | 2.862480 | | |
| 58 | 232.22064 | 44.183443 | SiO$_2$ | G$_6$ |
| 59 | 350.03691 | 19.466219 | | |
| 60 | (Wafer) | | | |

The silica glass and crystalline calcium fluoride that have these characteristics were used as lens materials of the construction of the projection optical system of FIG. 2. Also, the above mentioned silica glass and crystalline calcium fluoride optical members had, at 250 mm aperture and 70 mm thickness, a maximum refractive index differential

$\Delta n$ less than or equal to $2 \times 10^{-6}$ and a maximum birefringence less than or equal to 2 nm/cm.

The projection optical system thus manufactured showed the throughput exceeding 80%. Furthermore, the thus manufactured projection optical system attained a line spacing resolution of 0.19 $\mu$m, which is superior image forming performance for an ArF excimer laser steppers.

It will be apparent to those skilled in the art that various modifications and variations can be made in the optical member and the projection optical system for photolithography using the same of the present invention without departing from the spirit or scope of the invention. Thus, it is intended that the present invention cover the modifications and variations of this invention provided they come within the scope of the appended claims and their equivalents.

**Claims**

1. An optical member used by a photolithography projection system having a sub-200 nm wavelength vacuum ultraviolet light source, the optical member comprising:

   silica glass haivng an ArF excimer laser-induced bulk attenuation coefficient $\Delta\gamma$ that substantially satisfies the equation, $\Delta\gamma = ks \cdot \varepsilon^2 \cdot P^1$ when an ArF excimer laser with an energy density less than or equal to about 200 mJ/cm$^2$ per pulse is used for illumination,
   wherein ks is less than about $9.1 \times 10^{-13}$ cm$^{-1}$, $\varepsilon$ is per pulse energy density, P is pulse count, and ks is a proportionality constant.

2. The optical member according to claim 1, wherein the bulk attenuation coefficient is less than about 0.036 cm$^{-1}$ at a wavelength of ArF excimer laser light after illumination by $10^6$ pulses of ArF excimer laser light at a per pulse energy density of 200 mJ/cm$^2$.

3. An optical member used by a photolithography projection system using a vacuum ultraviolet light source with a wavelength less than 200 nm, the optical member comprising:

   crystalline calcium fluoride having an ArF excimer laser-induced bulk attenuation coefficient $\Delta\gamma$ that substantially satisfies the equation, $\Delta\gamma = kc \cdot \varepsilon^\alpha$ when an ArF excimer laser with an energy density of less than about 20 mJ/cm$^2$ per pulse is used for illumination,
   wherein $\varepsilon$ is per pulse energy density, $\alpha$ is at least about 0.1 and less than or equal to about 1.0, and kc is a proportionality constant that is less than or equal to about 0.005$\alpha$ cm$^{-1}$. cm$^{-1}$, $\varepsilon$ is per pulse energy density, P is pulse count and ks is a proportionality constant.

4. The optical member according to claim 3, wherein the bulk attenuation coefficient is less than about 0.1 cm$^{-1}$ at a wavelength of ArF excimer laser light after illumination of the crystalline calcium fluoride by $10^4$ pulses of ArF excimer laser light at a per pulse energy density of 20 mJ/cm$^2$.

5. A projection system for photolithography using a vacuum ultraviolet light source with a wavelength less than about 200 nm, the projection system comprising the optical member of claim 1 or claim 3.

6. A projection system for photolithography using a vacuum ultraviolet light source with a wavelength less than about 200 nm, the projection system comprising the optical member of claim 2 or claim 4.

**FIG. 1**

**FIG. 2**